# EUROPEAN PATENT APPLICATION

(11) **EP 2 806 434 A1**
(43) Date of publication of application: **26.11.2014**
(21) Application number: 14163537.5
(22) Date of filing: 04.04.2014
(51) Int. Cl.: H01F 27/06, H01F 38/30, G01R 15/18, G01R 19/25

(54) **Apparatus for current-monitoring and system for current-monitoring using the same**

(30) Priority: 21.05.2013 KR 20130056915
(71) Applicant: Feelux Co., Ltd., Gyeonggi-do 482-844 (KR)
(72) Inventor: Noh, Si-Chung, 482-844 Gyeonggi-do (KR)
(74) Representative: Scheele, Friedrich

(57) **Abstract**

Disclosed are a current monitoring apparatus for monitoring an electrical current flowing through a wire, and a current monitoring system using the same. The current monitoring apparatus includes a power generation part connected to a wire to generate alternating current (AC) power due to electromagnetic induction with the wire, and a current measurement part connected to the wire and measures the electrical current flowing through the wire. The current monitoring apparatus uses the power generated by the power generation part.

## Description

### CROSS REFERENCE TO RELATED APPLICATION

This application claims the benefit of Korean Patent Application No. 10-2013-0056915, filed on May 21, 2013, which is hereby incorporated by reference in its entirety into this application.

### BACKGROUND

### Field of the Invention

The present invention relates, in general, to technology for monitoring an electrical current of a load and, more particularly, to a current monitoring apparatus that can be autonomously supplied with power while monitoring an electrical current of a load, and a current monitoring system using the same.

### Description of the Related Art

In general, various loads have been used in private houses or buildings. In this case, when an abnormal current flows through the load, a fire may break out. In recent years, to reduce such a risk, many current monitoring apparatuses for warning of the abnormal current when the abnormal current is detected have been developed and used.

Here, conventional current monitoring apparatuses are generally supplied with power from a separate external power supply. In this case, since the current monitoring apparatuses should be electrically connected to a commercial power supply, they are restricted by their installation positions. Thus, the mobility of such a product is decreased. On the other hand, when the current monitoring apparatuses are not supplied with power from an external power supply, a separate battery should be installed in the current monitoring apparatuses. In this case, a space wherein the battery is installed should be provided in the current monitoring apparatuses. As such, the size of the current monitoring apparatus oftentimes increases. Accordingly, manufacturing costs rise. Further, the remaining power capacity of the battery should be frequently checked and replaced as needed.

### SUMMARY

Accordingly, in one embodiment of the present invention is a current monitoring apparatus that can be autonomously supplied with power without a separate power supply and monitor an electrical current of a load, and a current monitoring system using the same.

In a first aspect of the present invention, provided is a current monitoring apparatus for monitoring an electrical current flowing through a wire, including: a power generation part connected to the wire, and configured to generate alternating current (AC) power due to electromagnetic induction with the wire; and a current measurement part connected to the wire, and configured to measure the electrical current flowing through the wire. The current monitoring apparatus uses the power generated by the power generation part.

According a second aspect of the present invention, provided is a current monitoring system, including: the current monitoring apparatus as set forth in the first aspect; and a server configured to receive a value of the electrical current flowing through the wire from the current monitoring apparatus, to analyze the received current value to set at least one reference current value, and to transmit the set reference current value to the current monitoring apparatus.

According another aspect of the present invention, the current monitoring apparatus or system converts a magnetic field occurring near a wire through which an electrical current flows into an electrical current using electromagnetic induction so as to be autonomously supplied with power. Thus, the current monitoring apparatus or system does not need to be electrically connected to an external power supply in order to receive power. As such, the current monitoring apparatus and system are not restricted by an installation position, and thereby can increase mobility. Further, since a separate battery for supplying power is not required, the size of the current monitoring apparatus or system can be reduced, and the resultant costs can also be reduced. The current monitoring apparatus is installed around the wire using a circular chuck. Therefore, the current monitoring apparatus can be easily installed around the wire without separating the wire.

### BRIEF DESCRIPTION OF THE DRAWINGS

The present invention will be more clearly understood from the following detailed description when taken in conjunction with the accompanying drawings, wherein:
FIG. 1 shows a current monitoring system according to an embodiment of the present invention;
FIG. 2 shows a current monitoring apparatus according to an embodiment of the present invention;
FIG. 3 shows a configuration of the current monitoring apparatus according to one embodiment of the present invention; and
FIG. 4 is a circuit diagram of a load interrupting unit among components of the current monitoring apparatus according to one embodiment of the present invention.

### DETAILED DESCRIPTION

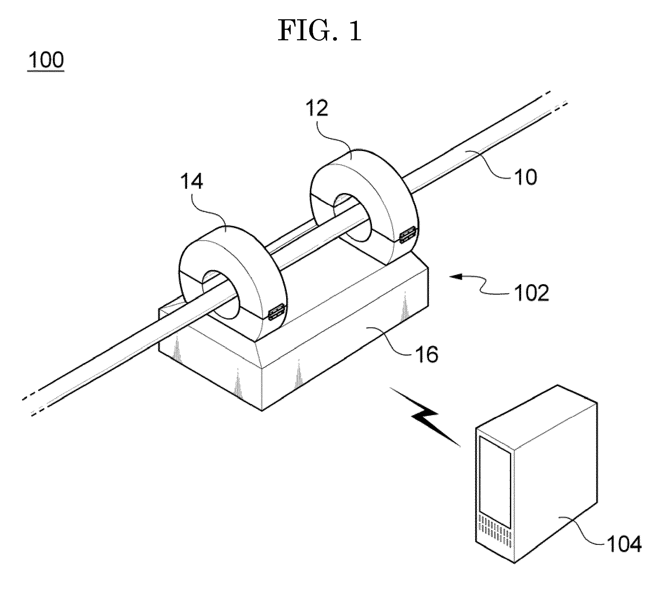

Hereinafter, specific embodiments of a current monitoring apparatus and a current monitoring system using the same will be described with reference to FIGS. 1 to 4. However, specific embodiments are merely exemplary embodiments, and the present invention is not limited thereto.

In the following description, when a detailed description of known technology related to the present invention is considered to unnecessarily obscure the subject matter of the present invention, the detailed description of the known technology will be omitted. Further, the terms to be described below are terms defined in consideration of the functions of the present invention, which may vary according to the intention or practices of a user or an operator, and therefore, the terms should be defined based on the content described throughout the specification.

The following examples are merely intended to effectively describe the advanced technical idea of the present invention to those skilled in the art.

FIG. 1 is a view of a current monitoring system according to an embodiment of the present invention.

Referring to FIG. 1, a current monitoring system 100 includes a current monitoring apparatus 102 and a server 104. The current monitoring apparatus 102 includes a power generation part 12, a current measurement part 14, and a body 16. The current monitoring apparatus 102 may be installed around a wire 10.

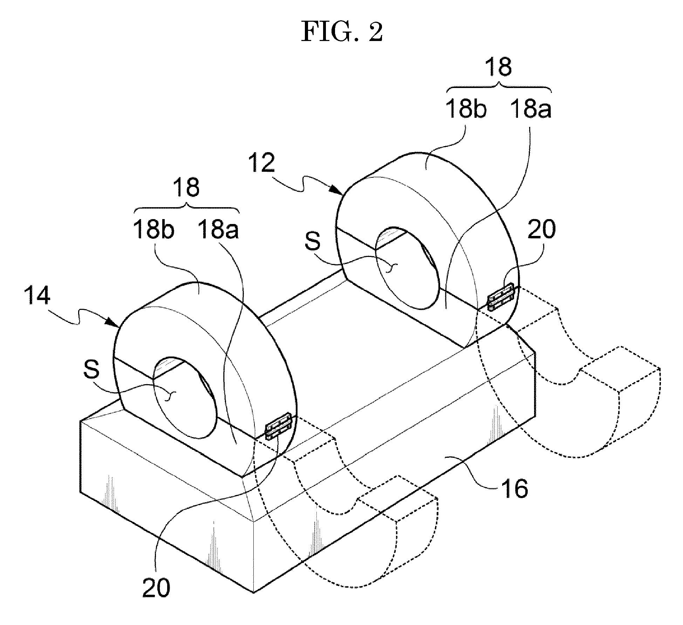

The power generation part 12 and the current measurement part 14 are provided for the body 16, and connected to the wire 10. The power generation part 12 and the current measurement part 14 may have a circular chuck shape. In this case, the power generation part 12 and the current measurement part 14 can be easily connected to the wire 10. The shapes of the power generation part 12 and the current measurement part 14 will be described in greater detail in FIG. 2.

The power generation part 12 generates power using electromagnetic induction caused by an electrical current flowing through the wire 10. The power generation part 12 supplies the generated power to the current monitoring apparatus 102. In other words, since the current monitoring apparatus 102 uses the power that is autonomously generated by the power generation part 12, the current monitoring apparatus 102 does not need to be electrically connected to an external power supply in order to receive power. Thus, the current monitoring apparatus 102 is not restricted by an installation position, and the mobility thereof can be increased. In addition, the current monitoring apparatus 102 does not require a separate battery. As such, the size of the current monitoring apparatus 102 can be reduced, and the resultant costs can also be reduced.

The current measurement part 14 functions to measure the electrical current flowing through the wire 10. The current measurement part 14 measures a value of the electrical current flowing through the wire 10, and transmits the current value to the body 16.

The power generation part 12 and the current measurement part 14 may be formed on the top of the body 16. The body 16 compares a reference current value set by the server 104 with a value of an electrical current that is currently flowing through the wire 10. In this case, when the value of the electrical current that is currently flowing through the wire 10 exceeds the set reference current value, the body 16 may interrupt a load, or inform a user or a manager of an abnormal sign of the load via an alarm (e.g., a warning sound, a light, message transmission, etc.) according to the result of the comparison. Further, the body 16 may transmit the current value measured by the current measurement part 14 to the server 104. In this case, the body 16 may transmit the measured current value to the server 104 temporally or in real-time. However, the present invention is not limited thereto. The current value measured by the current measurement part 14 may be transmitted by a request from the server 104. In addition, the body 16 may receive the reference current value from the server 104 again, and update the reference current value.

The server 104 receives the value of the electrical current that is currently flowing through the wire 10 from the current monitoring apparatus 102. The server 104 may communicate with the current monitoring apparatus 102 via at least one wire or wirelessly. The server 104 may analyze the current value received for a predetermined period of time and set the reference current value. In this case, the server 104 may calculate an average current consumption value of the load using the received current values, and add the average current consumption value and margin current values to set various reference current values. An example of a reference current value may be an overcurrent value that exceeds the average current consumption value, but can be sufficiently handled by a load and may be given and set as an alarm current value. In this case, a margin current value of the alarm current value may be set to 10% of the average current consumption value. Further, the alarm current value is a current value obtained by adding the average current consumption value and the margin current value that corresponds to 10% of the average current consumption value. Another example of a reference current value may be an overcurrent value that exceeds the average current consumption value and has to be interrupted from a load, and set as a cutoff current value. In this case, the margin current value of the cutoff current value may be set to 20% of the average current consumption value. Further, the cutoff current value is a current value obtained by adding the average current consumption value and the margin current value that corresponds to 20% of the average current consumption value. As described above, the server 104 may set the reference current value including at least one of the average current consumption values, the alarm current value, and the cutoff current value. Here, it has been described that the margin current value of the alarm current value is set to 10% of the average current consumption value, and the margin current value of the interrupting current value is set to 20% of the average current consumption value. However, the present invention is not limited thereto. The margin current value can also be differently set according to the load and the average current consumption value. The server 104 transmits the set reference current value to the current monitoring apparatus 102 via at least one wire or wirelessly, compares the set reference current value with a present current value, and checks a state of the electrical current flowing through the load so as to be able to monitor whether the load is normal or abnormal. In addition, the server 104 can display whether the load is normal or abnormal on a monitor.

FIG. 2 shows a current monitoring apparatus according to an embodiment of the present invention. Referring to FIG. 2, the power generation part 12 and the current measurement part 14 may include semicircular chucks 18, respectively.

Each chuck 18 includes a first support 18a and a second support 18b that are provided to face each other. One side of the second support 18b is hinged to the first support 18a via hinge 20. Further, the other side of the second support 18b is separated from the first support 18a. The chuck 18 may be opened via the second support 18b. When the chuck 18 is closed, a space S is defined by the chuck 18. The wire 10 is inserted into the space S. The current monitoring apparatus 102 can be easily connected to the wire 10 using the chuck 18. Here, it is shown that the first support 18a and the second support 18b are hinged by hinge 20. However, the present invention is not limited thereto. One side of the second support 18b may be partly formed integrally with the first support 18a. In addition, it is shown herein that the current measurement part 14 and the power generation part 12 are separately provided. However, the power generation part 12 and the current measurement part 14 may be integrally formed.

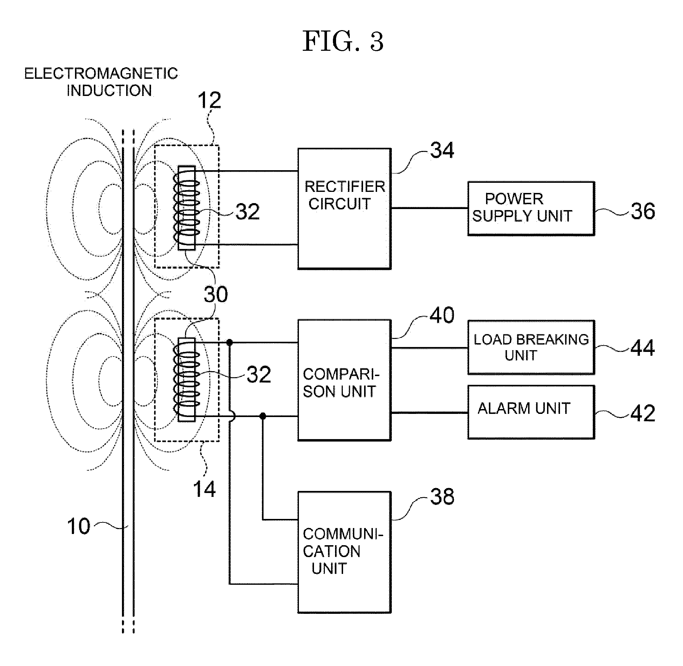

FIG. 3 shows a configuration of the current monitoring apparatus according to one embodiment of the present invention. Referring to FIG. 3, the current monitoring apparatus 102 includes the power generation part 12, the current measurement part 14, a rectifier circuit 34, a power supply unit 36, a communication unit 38, a comparison unit 40, an alarm unit 42, and a load breaking unit 44.

The power generation part 12 includes a core 30 and a coil 32. The core 30 and the coil 32 are housed in each of the chucks 18. The coil 32 is wound around the core 30 at least once. Here, the coil 32 is wound around the core 30. However, the present invention is not limited thereto. The coil 32 may be wound around the chuck 18 without the core 30. The power generation part 12 generates power using electromagnetic induction caused by an electrical current flowing through the wire 10. In this case, the power generation part 12 generates alternating current (AC) power.

The current measurement part 14 measures the electrical current flowing through the wire 10. The current measurement part 14 may include the core 30 and the coil 32. Here, the core 30 and the coil 32 of the power generation part 12 and the core 30 and the coil 32 of the current measurement part 14 may be integrally formed.

The rectifier circuit 34 is electrically connected to the coil 32 of the power generation part 12. The rectifier circuit 34 functions to convert the AC power generated by the power generation part 12 into direct current (DC) power. Specifically, when the wire 10 is supplied with commercial AC power, the AC power flows through the wire 10. Thus, a magnetic field is generated in proportion to a magnitude of the AC power along the wire 10. In this case, a variation in the magnetic field occurs near the wire 10 according to a variation in polarity of the AC. Then, an induced current is generated from the coil 32 by the variation in the magnetic field of the wire 10, and thus the electrical current flows through the coil 32. Since the electrical current in this case is AC, the rectifier circuit 34 converts the AC power into DC power. Here, a DC-to-DC converter that converts the DC power converted by the rectifier circuit 34 into the DC power used in the current monitoring apparatus 102 may be further provided.

The power supply unit 36 is electrically connected to the rectifier circuit 34. The power supply unit 36 functions to supply the DC power converted by the rectifier circuit 34 to the components of the current monitoring apparatus 102. In this way, the current monitoring apparatus 102 may be autonomously supplied with power by the power supply unit 36 without a commercial external power supply or a separate battery.

The communication unit 38 may be electrically connected to the coil 32 of the current measurement part 14. The communication unit 38 transmits the current value measured by the current measurement part 14 to the server 104. In this case, the communication unit 38 may transmit the measured current value in real-time or temporally. Alternatively, the measured current value may be transmitted by a request of the server 104. The communication unit 38 may receive the reference current value from the server 104, and transmit the reference current value to the comparison unit 40.

The comparison unit 40 may compare the reference current value received from the communication unit 38 with the value of the electrical current that is currently flowing though the wire 10 (i.e., the current value measured by the current measurement part 14), and generate an abnormal load notification signal according to the result of the comparison. For example, when the currently measured current value exceeds the alarm current value among the reference current values (i.e., exceeds the value corresponding to 10% of the average current consumption value), the comparison unit 40 may generate an alarm operation signal for the alarm unit 42. Also, when the currently measured current value exceeds the interrupting current value among the reference current values (i.e., exceeds the value corresponding to 20% of the average current consumption value), the comparison unit 40 may generate a load breaking operation signal in the load breaking unit 44.

When the alarm operation signal is generated by the comparison unit 40, the alarm unit 42 may warn a user or a manager about the current state of the load. Here, the value of the electrical current flowing through the load is the alarm current value that exceeds the average current consumption value, but can be sufficiently accepted by the load. Thus, the electrical current may be continuously supplied to the load. However, the alarm current value has already exceeded the average current consumption value, and has a risk of being changed to the interrupting current value according to the state of the load. Therefore, the alarm unit 42 may warn of such a risk in advance. In this case, the alarm unit 42 may generate an alarm sound, or give warning using a method of transmitting an alarm message to the operator. However, the present invention is not limited thereto. Earlier warnings may be given using various other methods.

When the load breaking operation signal is generated by the comparison unit 40, the load breaking unit 44 functions to interrupt the electrical current so that the electrical current is no longer supplied to the load. The load breaking unit 44 may be provided inside the current monitoring apparatus 102, or be separately provided outside the current monitoring apparatus 102.

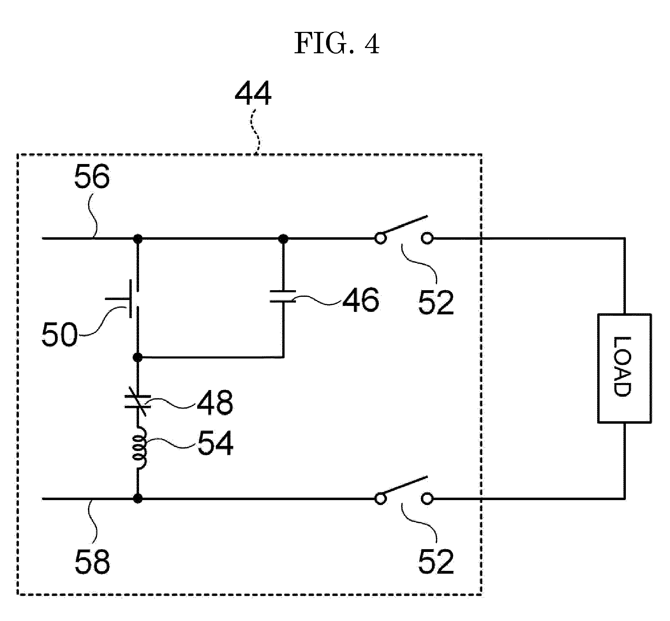

FIG. 4 is a circuit diagram of a load interrupting unit among components of the current monitoring apparatus according to one embodiment of the present invention.

Referring to FIG. 4, the load breaking unit 44 includes an arbeit contact 46, a break contact 48, a button 50, breakers 52, and a magnetic coil 54. The arbeit contact 46, the break contact 48, the button 50, and the magnetic coil 54 are provided between a first wire 56 and a second wire 58. The breakers 52 are provided for each of the first wire 56 and the second wire 58. Here, it is shown that the breakers 52 employ magnetic contact breakers. However, the present invention is not limited thereto. Various other breakers may be used.

During normal operation, the arbeit contact 46 of the load breaking unit 44 is opened, and the break contact 46 is closed. In this case, the first wire 56 and the second wire 58 of the load breaking unit 44 are opened. Thus, the electrical current does not flow. Here, when the button 50 is pressed, the arbeit contact 46 is changed from an opened state to a closed state, and the break contact 48 maintains a closed state. Therefore, the electrical current can flow through the first wire 56 and the second wire 58. During this time, the breakers 52 are connected to the first wire 56 and the second wire 58 by the magnetic coil 54, thereby causing the electrical current to flow through the load.

In this state, when the load breaking operation signal is generated (i.e., when the electrical current exceeding the cutoff current value flows through the load), the load breaking unit 44 opens the break contact 48, and thus the arbeit contact 46 also becomes open. As such, the first wire 56 and the second wire 58 are opened. Here, the breakers 52 are opened by the magnetic coil 54, thereby preventing the electrical current from flowing through the load. As described above, when the electrical current that exceeds the cutoff current value flows through the load, the load breaking unit 44 opens the breakers 52 to interrupt the electrical current so as to prevent the electrical current from flowing through the load. Accordingly, it is possible to quickly prevent a fire.

Although exemplary embodiments of the present invention have been described for illustrative purposes, those skilled in the art will appreciate that various modifications, additions and substitutions are possible, without departing from the scope and spirit of the invention as disclosed in the accompanying claims.

## Claims

1. A current monitoring apparatus for monitoring an electrical current flowing through a wire, the apparatus comprising:
a power generation part connected to the wire, the power generation part that generates alternating current (AC) power due to electromagnetic induction with the wire; and
a current measurement part connected to the wire, current measurement part that measures the electrical current flowing through the wire.,
wherein the current monitoring apparatus uses the power generated by the power generation part.

2. The current monitoring apparatus as set forth in claim 1, further comprising:
a rectifier circuit that rectifies the AC power generated by the power generation part to direct current (DC) power; and
a power supply unit that supplies the rectified DC power to components of the current monitoring apparatus.

3. The current monitoring apparatus as set forth in claim 1, further comprising a communication unit to transmit a current value measured by the current measurement part to a server, and to receive a reference current value from the server.

4. The current monitoring apparatus as set forth in claim 1, further comprising a comparison unit to compare a current value measured by the current measurement part with at least one of preset reference current values, and to generate an abnormal load notification signal when the measured current value exceeds the reference current value.

5. The current monitoring apparatus as set forth in claim 4, wherein:
the reference current value includes at least one of an alarm current value and a cutoff current value; and
the comparison unit generates an alarm operation signal when the current value measured by the current measurement part exceeds the alarm current value, and a cutoff operation signal when the current value measured by the current measurement part exceeds the cutoff current value.

6. The current monitoring apparatus as set forth in claim 5, further comprising:
an alarm unit that warns of a state of the electrical current flowing through the wire when the alarm operation signal is generated; and
a load breaking unit that interrupts the electrical current flowing through the wire when the cutoff operation signal is generated.

7. The current monitoring apparatus as set forth in claim 1, wherein the power generation part and the current measurement part are formed in a circular chuck shape, and connected to the wire.

8. The current monitoring apparatus as set forth in claim 1, wherein the power generation part and the current measurement part are formed integrally with a body of the current monitoring apparatus, and connected to the wire.

9. A current monitoring system comprising:
the current monitoring apparatus as set forth in any one of claims 1 to 8; and
a server to receive a value of the electrical current flowing through the wire from the current monitoring apparatus, to analyze the received current value to set at least one reference current value, and to transmit the set reference current value to the current monitoring apparatus.

10. The current monitoring system as set forth in claim 9, wherein the server measures an average current consumption value flowing through the wire using the current value received during a preset period of time from the current monitoring apparatus, and adds the average current consumption value and a margin current value to set the at least one reference current value.
